## Europäisches Patentamt
## European Patent Office
## Office européen des brevets

(11) Veröffentlichungsnummer: **0 151 428**
A2

(12) **EUROPÄISCHE PATENTANMELDUNG**

(21) Anmeldenummer: 85100626.2

(22) Anmeldetag: 22.01.85

(51) Int. Cl.⁴: **B 26 B 19/38**

(30) Priorität: 30.01.84 DE 8402561 U

(43) Veröffentlichungstag der Anmeldung:
14.08.85 Patentblatt 85/33

(84) Benannte Vertragsstaaten:
AT DE FR GB NL

(71) Anmelder: Braun Aktiengesellschaft
Rüsselsheimer Strasse 22
D-6000 Frankfurt/Main(DE)

(72) Erfinder: Schweingruber, Otto
Höhenblick 1
D-6246 Glashütten 1(DE)

(74) Vertreter: Einsele, Rolf
Braun Aktiengesellschaft Postfach 1120 Frankfurter
Strasse 145
D-6242 Kronberg Taunus(DE)

(54) Vorrichtung zur lösbaren Halterung des Motorchassis in einem quergeteilten Gehäuse eines elektrisch betriebenen Kleingerätes.

㋝ Elektrisch betriebenes Kleingerät mit einem quergeteilten Gehäuse, indem ein den Motor tragendes Motorchassis untergebracht ist, das mittels am Gehäuseoberteil vorgesehener federnden Krallen gegen Anschläge im Gehäuseoberteil gehalten ist, wobei die federnden Krallen durch das sie umgebende Gehäuseunterteil gegen Ausfedern gesperrt sind.

FIG.1

EP 0 151 428 A2

Die Erfindung betrifft ein elektrisch betriebenes Kleingerät z.B. Trockenrasierapparat, Zahnbürste, Massagegerät oder dergleichen mit einem quergeteilten Gehäuse bestehend aus einem haubenförmigen Oberteil, das mit einem die Teilungsöffnung umgebenden Sims versehen ist und einem Gehäuseunterteil, das einen umfangsgeschlossenen Mantel hat, der, das Gehäuse schließend, am Sims angreift.

Bei bekannten Vorrichtungen dieser Art (JP-B2 45-16994, DE-AS 1 044 670) sind entweder mehrere Schraubenverbindungen als Mittel zur Halterung eines Chassis vorgesehen oder relativ bauaufwendige, formschlüssige Verbindungen mit einer Vielzahl von Einzelteilen, die sowohl die Fertigung als auch die Montage umständlich gestalten und somit verteuern.

Aufgabe der Erfindung ist es, eine sichere und definierte Halterung für den Motor eines elektrisch betriebenen Kleingerätes zu schaffen, den Bauaufwand für diese Halterung zu vermindern, sowie die Montage der erforderlichen Bauteile zu vereinfachen, um die Herstellung des gesamten Kleingerätes wirtschaftlicher zu gestalten.

Nach der Erfindung wird diese Aufgabe dadurch gelöst, daß in dem quergeteilten Gehäuse ein den Motor tragendes Motorchassis, vorgesehen ist, das an Anschlägen am Gehäuseoberteil anliegt, daß am Gehäuseoberteil das Motorschassis von außen umgreifende, federnde Krallen vorgesehen sind, die am Sims aus der Öffnung des Gehäuseoberteils herausragend, soweit nach innen versetzt angebracht sind, daß der am Sims angreifende Mantel des Gehäuseunterteils an den Krallen anliegt und diese gegen Ausfedern sperrt.

Zweckmäßigerweise ist vorgesehen, daß das Gehäuseoberteil mit dem Gehäuseunterteil gegeneinander verspannt ist mittels einer

...

Braun Aktiengesellschaft

0151428

Schraubenverbindung, die einerseits im Boden des Gehäuseunterteils gelagert und andererseits in das Motorchassis ein- bzw.
ausschraubbar ist.

Weitere Vorteile und Einzelheiten der Erfindung ergeben sich aus
der nachfolgenden Beschreibung und der Zeichnung, in denen ein
bevorzugtes Ausführungsbeispiel dargestellt ist, und zwar zeigen:

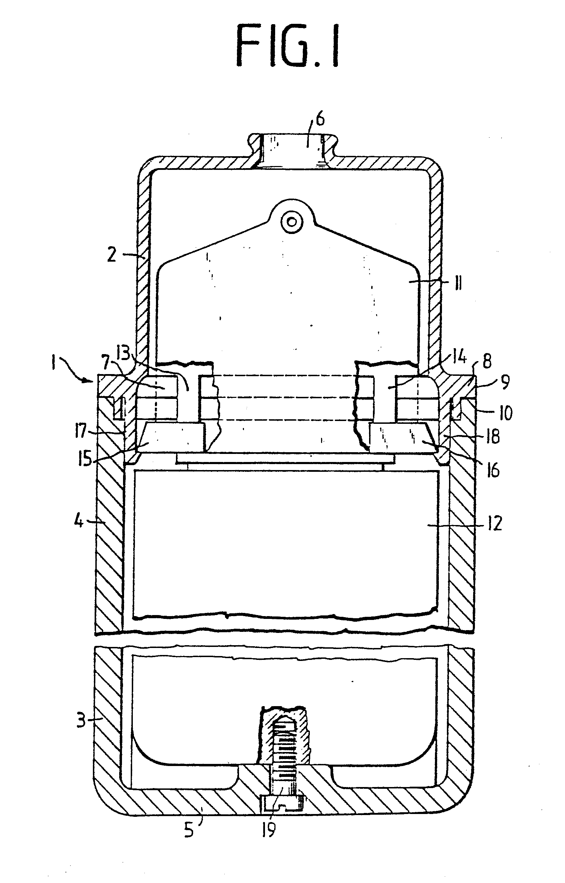

Fig. 1  einen Längsschnitt durch das Gehäuse eines Trockenrasierapparates mit einem darin angeordneten Motorchassis;

Fig. 2  eine Schmalseite eines Trockenrasierapparategehäuses mit
einem Teilschnitt durch Gehäuseoberteil, Gehäuseunterteil
und Motorchassis im Bereich der federnden Krallen.

Das quergeteilte Gehäuse 1 des elektrischen Kleingerätes, z.B.
eines Trockenrasierapparates, besteht aus einem haubenförmigen
Gehäuseoberteil 2 und einem etwa becherförmigen Gehäuseunterteil 3, das mit einem umfangsgeschlossenen Mantel 4 versehen ist.
Bei diesem Gehäuseunterteil 3 kann auch der Boden 5 vom Mantel 4
getrennt und an diesen angesetzt sein, wie dies an sich bekannt
ist.

Das Gehäuseoberteil 2 hat oben eine kleine Öffnung 6, durch die
der nicht dargestellte Antriebshebel für das Werkzeug des Kleingerätes hindurchragen kann, und unten die Teilungsöffnung 7, die
von einem abgestützten Sims 8 umgeben ist. Am Sims 8 greift in
der Schließstellung beider Gehäuseteile 2 und 3 der Mantel 4 in
der Weise an, daß die Außenflächen 9 und 10 des Sims 8 und des
Mantels 4 bündig sind. Im Gehäuse 1, hier speziell im Gehäuseoberteil 2 ist das Motorchassis 11 für den daran montierten Motor
12 gehaltert. Zu diesem Zweck sind im Gehäuseoberteil 2 Anschläge

...

13 und 14 angeformt, an denen das in das Gehäuse 1 eingeschobene Motorchassis 11 mit Vorsprüngen 15 und 16 zur Anlage kommt. Am Sims 8 sind auf der Innenseite der Teilungsöffnung 7 auf gegenüberliegenden Seiten nach unten herausragende, federnde Krallen 17 und 18 angebracht, die, das Motorchassis 11 von außen umgreifend, an den Vorsprüngen 15 und 16 einrasten und auf diese Weise das Motorchassis lösbar haltern. Die beiden Krallen 17 und 18 sind, von der Außenfläche 9 des Sims 8 her gesehen, etwa um die Dicke des Mantels 4 nach innen versetzt, so daß der Mantel 4 im aufgeschobenen Zustand an den Krallen 17 und 18 außen anliegt und sie damit gegen Ausfedern sperrt. Auf diese einfache Weise ist das bei zerlegtem Gehäuse leicht aus seiner Halterung lösbare bzw. in diese einsetzbare Motorchassis bei montiertem Gehäuse gegen unbeabsichtigtes Lösen, etwa hervorgerufen durch Stöße und Erschütterungen, gesichert. Das Gehäuseunterteil 3 ist, durch eine am Boden 5 eingesetzte und am Motor 12 oder einem seiner Bauelemente, wie Motorchassis 11, angreifende zentrale Schraube 19 gegen das Gehäuseoberteil 2 verspannt.

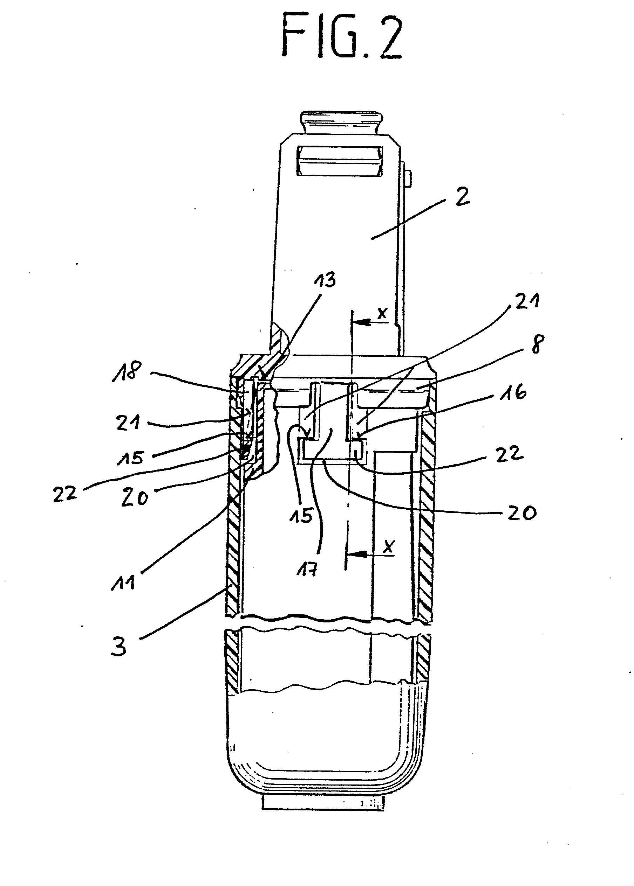

Die Ausführungsform nach Fig. 2 zeigt eine der Schmalseiten eines aus einem Gehäuseoberteil 2 und einem Gehäuseunterteil 3 bestehenden Gehäuses 1. Auf beiden Schmalseiten des Gehäuses 1 ist jeweils am umlaufenden Sims 8 des Gehäuseoberteils 2 eine federnde Kralle 17 angeformt, wovon eine aus der Darstellung ersichtlich ist. Eine weitere federnde Kralle 18 ist auf der Breitseite des Gehäuses 1 am Sims 8 angeformt. Die federnden Krallen 17 und 18 weisen eine T-förmige Gestalt auf, wobei der Fuß des T-Balkens in den Sims 8 übergeht. In dem Motorchassis 11 sind, die federnden Krallen 17, 18 aufnehmende, T-förmige Ausnehmungen 20 eingeformt. Beiderseits des vertikal verlaufenden Bereiches der Ausnehmungen 20 sind parallel verlaufende Auflauframpen 21 in das Motorchassis eingeformt, über die, die horizontal verlaufenden Balkenteile 22 der T-förmigen Krallen gleitend in die Ausnehmungen 20 geführt werden.

...

Einzelheiten des mit x-x angegebenen Schnittes durch die Kralle 17, die Wand des Motorchassis 11 und des Simses 8 des Gehäuseoberteils 2 ergeben sich aus der Schnittdarstellung des Bereiches um die federnde Kralle 18.

Im Gehäuseoberteil 2 ist wenigstens ein Anschlag 13 und/oder 14 vorgesehen. Im montierten Zustand von Gehäuseoberteil 2 und Motorchassis 11 liegt das Motorchassis 11 an dem Anschlag 13 und/oder 14 an. In die äußere Wandung die Motorchassis 11 ist eine T-förmige Ausnehmung 20 eingeformt, wodurch Vorsprünge 15 und 16 gebildet werden, an die der horizontal verlaufende T-Balken 22 der eingefederten Kralle 18 zur Anlage kommt. Die Innenwand des horizontal verlaufenden Balkenteils 22 der T-förmigen Kralle 18 ist abgeschrägt. Die Steigung der Abschrägung entspricht der Steigung der beiderseits des vertikal verlaufenden Bereiches der T-förmigen Ausnehmung 20 in die Gehäusewand des Motorchassis 11 eingeformten Auflauframpen 21. Schiebt man das Motorchassis 11 zwischen den federnden Krallen 17 und 18 in Richtung der Anschläge 13 und 14, dann gleiten die abgeschrägten horizontal verlaufenden Balkenteile 22 über die Auflauframpen 21 und federn über die Vorsprünge 15 und 16 in die Ausnehmung 20 hinein und drücken das Motorchassis 11 gegen die Anschläge 13 und 14. Das auf den Sims 8 des Gehäuseoberteils 2 aufgeschobene Gehäuseunterteil 3 umgibt das Motorchassis 11 sowie die in die Ausnehmungen 20 eingefederten Krallen und hindert diese am ausfedern.

...

**0151428**

- 8 -

Bezugszeichenliste

1    Gehäuse

2    Gehäuseoberteil

3    Gehäuseunterteil

4    Mantel

5    Boden

6    Öffnung

7    Teilungsöffnung

8    Sims

9    Außenflächen

10   Außenflächen

11   Motorchassis

12   Motor

13   Anschläge

14   Anschläge

15   Vorsprünge

16   Vorsprünge

17   Krallen

18   Krallen

19   Schraube

20   Ausnehmung

21   Auflauframpen

22   horizontal verlaufender Balkenteil der T-förmigen Kralle

...

Braun Aktiengesellschaft

0151428

Patentansprüche

1. Elektrisch betriebenes Kleingerät z.B. Trockenrasierapparat, Zahnbürste, Massagegerät oder dergleichen mit einem quergeteilten Gehäuse bestehend aus einem haubenförmigen Oberteil, das mit einem die Teilungsöffnung umgebenden Sims versehen ist und einem Gehäuseunterteil, das einen umfangsgeschlossenen Mantel hat, der, das Gehäuse schließend, am Sims angreift, dadurch gekennzeichnet, daß in dem quergeteilten Gehäuse (2, 3) ein den Motor tragendes Motorchassis (11) vorgesehen ist, das an Anschlägen (13 und 14) am Gehäuseoberteil (2) anliegt, daß am Gehäuseoberteil (2) das Motorchassis (11) von außen umgreifende federnde Krallen (17 und 18) vorgesehen sind, die am Sims (8) aus der Öffnung des Gehäuseoberteils (2) herausragend, soweit nach innen versetzt angebracht sind, daß der am Sims (8) angreifende Mantel (4) des Gehäuseunterteils (3) an den Krallen (17 und 18) anliegt und diese gegen Ausfedern sperrt.

2. Elektrisch betriebenes Kleingerät nach Anspruch 1, dadurch gekennzeichnet, daß das Gehäuseoberteil (2) mit dem Gehäuseunterteil (3) gegeneinander verspannt ist mittels einer Schraubverbindung (19), die einerseits im Boden (5) des Gehäuseunterteils (3) gelagert und andererseits in das Motorchassis (11) ein- bzw. ausschraubbar ist.

...

Braun Form 10.407/1-10/83

# FIG.1

# FIG.2